(19) Europäisches Patentamt
European Patent Office
Office européen des brevets

(11) Publication number: **0 345 534 A1**

# (12) EUROPEAN PATENT APPLICATION

(21) Application number: **89109342.9**

(22) Date of filing: **24.05.89**

(51) Int. Cl.[4]: **C08G 77/24 , G03F 7/00**

(30) Priority: **25.05.88 JP 127284/88**

(43) Date of publication of application: **13.12.89 Bulletin 89/50**

(84) Designated Contracting States: **DE FR GB**

(71) Applicant: **TORAY SILICONE COMPANY, LIMITED**
**2-3-16, Muro-machi Nihonbashi**
**Chuo-ku Tokyo 103(JP)**

(72) Inventor: **Fukutani, Yoshimi**
**6,1-chome, Yushudai Nishi**
**Ichihara-shi Chiba Prefecture(JP)**

(74) Representative: **Spott, Gottfried, Dr. et al**
**Patentanwälte Spott und Puschmann**
**Sendlinger-Tor-Platz 11**
**D-8000 München 2(DE)**

## (54) Polyorganosiloxane with chloromethyl groups.

(57) Polyorganosiloxane which are useful as resist materials for use in microprocesses such as large scale integration device fabrication are those of the formula

$$[ClCH_2\overset{R^1}{\underset{R^1}{|Si|}}O_{1/2}]_x \; [R^2\overset{R^1}{\underset{R^1}{|Si|}}O_{1/2}]_y \; [SiO_{4/2}]_z$$

where $R^1$ is a monovalent hydrocarbon group having 1 to 6 carbon atoms; $R^2$ is a hydrogen atom or a monovalent hydrocarbon group having 1 to 6 carbon atoms; $x$ and $z$ are positive numbers; $y$ is zero or a positive number; and $x$, $y$, and $z$ have values such that their ratios are $0.3 \leq (x + y)/z \leq 4$; and zero $\leq y/x \leq 100$.

EP 0 345 534 A1

# POLYORGANOSILOXANE WITH CHLOROMETHYL GROUPS

The present invention relates to a novel polyorganosiloxane. More particularly, the present invention relates to a novel polyorganosiloxane which is sensitive and reactive to high-energy radiation such as ultraviolet radiation, electron beams, X-rays, etc.

Organic groups sensitive and reactive to high-energy radiation comprise those which generate a chain reaction, such as the epoxy group and the double bond, and those which generate a consecutive reaction, such as haloalkyl groups.

Within the realm of organopolysiloxanes which contain high energy radiation-sensitive organic groups which generate a consecutive reaction, one has recourse to di(alpha-chloromethylphenyl)polysiloxanes, which have been described in the literature.

However, chain reaction-type organic compounds are generally highly sensitive, and as a result polymerization can continue even after exposure to high-energy radiation. As a consequence of this, when such compounds are used in resist materials, the resolution of the resist is reduced.

With regard to consecutive reaction-type alphachloromethylphenyl group-containing organopolysiloxanes, the synthesis of these polymers is tedious, and it is difficult to control the titer or quantity of the high energy radiation-sensitive organic groups. In addition, the molecular weight and softening point cannot be controlled or adjusted.

Furthermore, there has as yet been no description of polyorganosiloxane having within a single molecule both tetrafunctional siloxane units and monofunctional triorganosiloxane units which contains the silicon-bonded chloromethyl group.

An object of the present invention is to provide a novel polyorganosiloxane whose synthesis is easy and straightforward and whose molecular weight, softening point, and titer of high energy radiation-sensitive organic groups can be easily regulated and adjusted.

This invention relates to a polyorganosiloxane with a molecular weight of 500 to 500,000 which has the following general formula

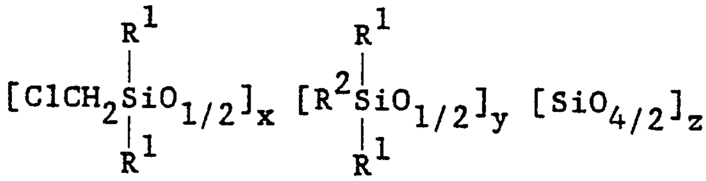

in which $R^1$ is a monovalent hydrocarbon group having 1 to 6 carbon atoms; $R^2$ is a hydrogen atom or a monovalent hydrocarbon group having 1 to 6 carbon atoms; x and z are positive numbers; y is zero or a positive number; and x, y, and z have values such that their ratios are $0.3 \leq (x + y)/z \leq 4$; and zero $\leq y/x \leq 100$.

To explain the preceding in greater detail, the group $R^1$ in the above formula is a monovalent hydrocarbon group having 1 to 6 carbon atoms. Examples of $R^1$ are alkyl groups such as methyl, ethyl, n-propyl, isopropyl, n-butyl, and isobutyl; alkenyl groups such as vinyl and allyl; and the phenyl group. Within the individual molecule, $R^1$ may comprise only a single species, or may comprise a combination of two or more different species. Furthermore, the group $A^2$ is the hydrogen atom or a monovalent hydrocarbon group having 1 to 6 carbon atoms, and the latter is exemplified as for $R^1$.

In addition, x and z are positive numbers, y is zero or a positive number, and it is essential that the ratio of x, y, and z have values such that $0.3 \leq (x + y)/z \leq 4$ and that zero $\leq y/x \leq 100$. When x, y, and z fall outside these ranges, synthesis becomes difficult and the sensitivity to high- energy radiation drops off. Furthermore, when x, y, and z satisfy $0.3 \leq (x + y)/z \leq 1.0$, the polyorganosiloxane of the present invention will be a solid at room temperature.

The molecular weight is to be 500 to 500,000 because synthesis becomes problematic outside this range.

Any of the following may be bonded to the tetrafunctional siloxane unit with the formula
$SiO_{4/2}$
in the polyorganosiloxane of the present invention: other tetrafunctional siloxane units with the formula
$SiO_{4/2}$,
monofunctional siloxane units with the general formula

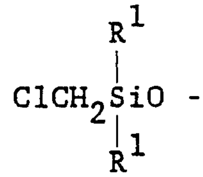

in which $R^1$ is defined as above, and monofunctional siloxane units with the general formula

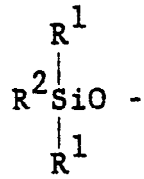

in which $R^1$ and $R^2$ are defined as above. In addition, polyorganosiloxane of the present invention may also contain minor quantities of hydroxyl groups, alkoxy groups, halogen atoms, etc., as residues from the synthesis process.

Preparation of the polyorganosiloxane of the present invention may be accomplished by the cohydrolysis and condensation reactions of $x$ moles hydrolyzable group-containing organosilane with the general formula

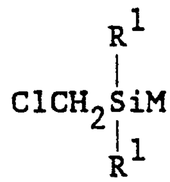

in which $R^1$ is defined as above, and M is a hydrolyzable group, $y$ moles hydrolyzable group-containing organosilane with the general formula

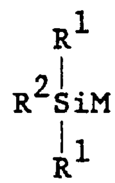

in which $R^1$, $R^2$, and M are defined as above, and $z$ moles hydrolyzable silane with the general formula
$SiM_4$
in which M is defined as above, wherein $x$, $y$, and $z$ are defined as above.

Examples of the hydrolyzable group M in the above formulas are halogen atoms such as the chlorine atom and bromine atom; alkoxy groups such as methoxy, ethoxy, isopropoxy, and methoxyethoxy; and acyloxy groups such as acetoxy.

The hydrolyzable group-containing organosilane with the general formula

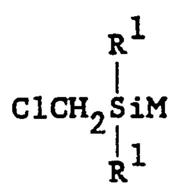

in which $R^1$ is defined as above, and M is a hydrolyzable group can be easily synthesized, for example, by the photochlorination of trimethylchlorosilane.

Solvents may be used during cohydrolysis, and examples are aromatic hydrocarbon solvents such as

benzene, toluene, and xylene; alcohol solvents such as methanol and ethanol; ketone solvents such as acetone; and chlorinated hydrocarbon solvents. Furthermore, an acid catalyst may be used to promote the hydrolysis and condensation reactions, and examples are hydrochloric acid, sulfuric acid, phosphoric acid, nitric acid, and acetic acid.

Merely by varying the molar ratio among the chloromethyl-containing monofunctional siloxane unit, the monofunctional siloxane unit not containing chloromethyl, and the tetrafunctional siloxane unit, it is possible freely to adjust the molecular weight, softening point, and sensitivity to high-energy radiation of polyorganosiloxane of the present invention. Also, because the polyorganosiloxane of the present invention cures by the development of a consecutive reaction upon exposure to high-energy radiation, one can contemplate practical application, inter alia, in resist materials for use in microprocesses in large scale integration device fabrication.

The following examples are presented for experimental purposes and should not be construed as limiting the invention which is properly delineated in the claims.

## EXAMPLE 1

The following ingredients were charged into a four-neck flask equipped with a stirrer, reflux condenser, addition funnel, and thermometer: 11.6 g (0.05 mol) 1,3-bis(alphachloromethyl)-1,1,3,3-tetramethyldisiloxane, 32.5 g (0.20 mol) hexamethyldisiloxane, 60 g water, 40 g concentrated hydrochloric acid, 20 g ethanol, and 30 g toluene. While stirring and heating to 70C°, 208.3 g (1.00 mol) tetraethoxysilane was dripped in over 2 hours. Heating under reflux was continued for 1 hour after the completion of the addition of the tetraethoxysilane. 100 g water was then added, and the polymer layer (lower layer) was separated off. The upper layer was extracted by the addition of 100 g water and 100 g toluene, and the aqueous layer was discarded. The toluene and polymer layers were combined, this was washed with water by the addition of 150 g toluene and 100 g water, and the aqueous layer was again discarded. The water was then removed by heating at the azeotrope. In order to cap residual silanol, 40 g hexamethyldi-silazane was added with heating under reflux for 6 hours. Filtration and removal of the solvent afforded 106 g of a white solid without a softening point. The results of analysis described a polyorganosiloxane which was this white solid at room temperature having the properties reported below.

$^1$HNMR delta (ppm): 0.3 (5.8H, br, $CH_3Si$), 1.3 (0.5H, br, $CH_3CH_2OSi$), 2.7 (0.2H, br, $ClCH_2Si$), 3.3 (0.3H, br, $CH_3CH_2OSi$)

$^{29}$SiNMR delta (ppm): 13 (0.57Si, br, $(CH_3)_3SiO_{1/2}$), 7 (0.11Si, br, $ClCH_2(CH_3)_2SiO_{1/2}$), -100 (0.16Si, br, $ROSiO_{3/2}$), -110 (0.84Si, br, $SiO_{4/2}$)

GPC (gel permeation chromatography):

$M_w$ (weight-average molecular weight) = $1.6 \times 10^4$

$M_n$ (number-average molecular weight) = $4.7 \times 10^3$

## EXAMPLE 2

The following ingredients were charged into a four-neck flask equipped with a stirrer, reflux condenser, addition funnel, and thermometer: 23.1 g (0.10 mol) 1,3-bis(alphachloromethyl)-1,1,3,3-tetramethyldisiloxane, 28.0 g (0.15 mol) 1,3-divinyl-1,1,3,3-tetramethyldisiloxane, 60 g water, 40 g concentrated hydrochloric acid, 20 g ethanol, and 30 g toluene. While stirring and heating at 70° C, 208.3 g (1.00 mol) tetraethoxysilane was dripped in over 2 hours. Heating under reflux was then continued for an additional 1 hour. Extraction of the polymer and post-treatment with hexamethyldisilazane according to the procedure in Example 1 afforded 107 g of a white solid without a softening point. The results of analysis described a polyorganosiloxane which was a white solid at room temperature having the properties reported below.

$^1$HNMR delta (ppm): 0.3 (4.2H, br, $CH_3Si$), 1.3 (0.4H, br, $CH_3CH_2OSi$), 2.7 (0.4H, br, $ClCH_2Si$), 3.3 (0.3H, br, $CH_3CH_2OSi$), 6.0 (0.9H, br, $CH_2=CH\text{-}Si$)

$^{29}$SiNMR delta (ppm): 13 (0.16Si, br, $(CH_3)_3SiO_{1/2}$), 7 (0.18Si, br, $ClCH_2(CH_3)_2SiO_{1/2}$), 0 (0.285i, br, $CH_2=CH\text{-}(CH_3)_2SiO_{1/2}$), -100 (0.13Si, br, $ROSiO_{3/2}$), -110 (0.87Si, br, SiO4/2)

GPC:

$M_w$ = $1.4 \times 10^4$

$M_n$ = $4.3 \times 10^3$

EXAMPLE 3

The following ingredients were charged into a four-neck flask equipped with a stirrer, reflux condenser, addition funnel, and thermometer: 100.2 g (0.70 mol) alpha-chloromethyldimethylchlorosilane, 208.3 g (1.00 mol) tetraethoxysilane, and 100 g toluene. While stirring and heating at 70 °C, a mixture of 60 g water, 40 g concentrated hydrochloric acid, and 20 g ethanol was dripped in over 2 hours. Heating under reflux was continued for an additional 4 hours after the completion of addition. 150 g water was added, and the polymer layer (lower layer) was separated off. This polymer layer was diluted with 250 g toluene, and the ethanol and water were removed azeotropically. 40 g hexamethyldisilazane was then added, and heating under reflux was carried out for 6 hours. Filtration and concentration of the filtrate afforded 115 g of a white solid with a softening point of approximately 110 °C. The results of analysis described a polyorganosiloxane which was a white solid at room temperature having the properties reported below.

$^1$HNMR delta (ppm): 0.3 (5.4H, br, $CH_3Si$), 1.3 (0.5H, br, $\underline{CH_3}CH_2OSi$), 2.7 (1.4H, br, $ClCH_2Si$), 3.3 (0.3H, br, $CH_3CH_2OSi$)

$^{29}$SiNMR delta (ppm): 13 (0.15Si, br, $(CH_3)_3SiO_{1/2}$), 7 (0.65Si, br, $ClCH_2(CH_3)_2SiO_{1/2}$), -100 (0.15Si, br, $ROSiO_{3/2}$), -110 (0.85Si, br, $SiO_{4/2}$)

GPC:

$M_w = 2.7 \times 10^3$

$M_n = 1.9 \times 10^3$

EXAMPLE 4

The following ingredients were charged into a four-neck flask equipped with a stirrer, reflux condenser, addition funnel, and thermometer: 35.8 g (0.25 mol) alpha-chloromethyldimethylchlorosilane, 27.2 g (0.25 mol) trimethylchlorosilane, 208.3 g (1.00 mol) tetraethoxysilane, and 100 g toluene. While stirring and heating to 70 °C, a mixture of 60 g water, 40 g concentrated hydrochloric acid, and 20 g ethanol was dripped in over 2 hours. Heating under reflux was continued for an additional 4 hours after the completion of addition. 150 g water was then added, and the polymer layer (lower layer) was separated off. This polymer layer was diluted with 250 g toluene, and the ethanol and water were removed azeotropically. 40 g hexamethyldisilazane was then added, followed by heating under reflux for 6 hours. Filtration and concentration of the filtrate then afforded 108 g of a white solid without a softening point. The results of analysis described a polyorganosiloxane which was a white solid at room temperature having the properties reported below.

$^1$HNMR delta (ppm): 0.3 (4.8H, br, $CH_3Si$), 1.3 (0.5H, br, $\underline{CH_3}CH_2OSi$), 2.7 (0.5H, br, $ClCH_2Si$), 3.3 (0.3H, br, $CH_3CH_2OSi$)

$^{29}$SiNMR delta (ppm): 13(0.38Si, br, $(CH_3)_3SiO_{1/2}$), 7 (0.22Si, br, $ClCH_2(CH_3)_2SiO_{1/2}$), -100 (0.16Si, br, $ROSiO_{3/2}$), -110 (0.84Si, br, $SiO_{4/2}$)

GPC:

$M_w = 2.4 \times 10^4$

$M_n = 5.4 \times 10^3$

EXAMPLE 5

The following ingredients were charged into a four-neck flask equipped with a stirrer, reflux condenser, addition funnel, and thermometer: 46.3 g (0.2 mol) 1,3-bis(alphachloromethyl)-1,1,3,3-tetramethyldisiloxane, 113.7 g (0.7 mol) hexamethyldisiloxane, 60 g water, 40 g concentrated hydrochloric acid, and 20 g ethanol. While stirring and heating at 70 °C, 208.3 g (1.00 mol) tetraethoxysilane was dripped in over 2 hours. Heating under reflux was then continued for an additional 1 hour. 150 g water was added to the obtained polymer, and the polymer layer was separated off. The obtained polymer layer was diluted with 250 g toluene, and the ethanol and water were removed azeotropically. 10 mg potassium hydroxide was then added, followed by heating under reflux for 3 hours in order to conduct a dehydration condensation of residual silanol. Neutralization with trimethylchlorosilane, filtration, and concentration of the filtrate afforded 210 g of a colorless liquid with a viscosity of approximately 200 cp. The results of analysis described a polyorganosiloxane which was colorless liquid at room temperature having the properties reported below.

$^1$HNMR delta (ppm): 0.3 (14.6H, br, $CH_3Si$), 1.3 (0.2H, br, $\underline{CH_3}CH_2OSi$), 2.7 (0.8H, br, $ClCH_2Si$), 3.3 (0.1H, br, $CH_3\underline{CH_2}OSi$)

$^{29}$SiNMR delta (ppm): 13 (1.36Si, br, $(CH_3)_3SiO_{1/2}$), 7 (0.40Si, br, $ClCH_2(CH_3)_2SiO_{1/2}$), -100 (0.08Si, br, $ROSiO_{3/2}$), -110 (0.92Si, br, $SiO_{4/2}$)
GPC:
$M_w$ = 1.2 x $10^3$
$M_n$ = 1.1 x $10^3$

EXAMPLE 6

The polyorganosiloxanes obtained in Example 1 through Example 4 were each dissolved in n-heptane to prepare 10 weight% solutions. The solutions were spin-coated on silicon wafers and dried to give polymer films with thicknesses of 0.5 micrometers. Curing occurred upon exposure to an electron beam (100 microC/cm$^2$, acceleration voltage = 25 kV), and redissolution in ethanol was then no longer possible.

EXAMPLE 7

The polyorganosiloxanes obtained in Example 1 through Example 4 were each spin-coated and formed into polymer films by the procedure of Example 6. Curing occurred upon exposure to X-rays (13.3 angstroms, 500 mJ/cm$^2$), and redissolution in ethanol was then no longer possible.

The present invention introduces a novel polyorganosiloxane whose synthesis is easy and whose molecular weight, titer of organic groups sensitive to high-energy radiation, and softening point can be easily adjusted or regulated.

## Claims

1. Polyorganosiloxane with a molecular weight of 500 to 500,000 which has the following general formula

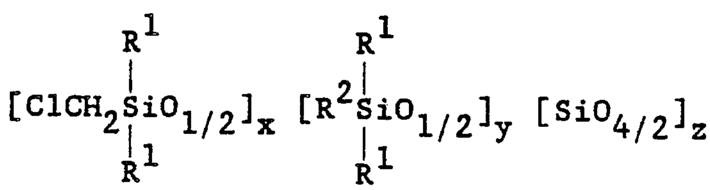

in which $R^1$ is a monovalent hydrocarbon group having 1 to 6 carbon atoms; $R^2$ is a hydrogen atom or a monovalent hydrocarbon group having 1 to 6 carbon atoms; x and z are positive numbers; y is zero or a positive number; and x, y, and z have values such that their ratios are $0.3 \leq (x + y)/z \leq 4$; and zero $\leq y/x \leq$ 100.

2. The polyorganosiloxane according to claim 1 which is solid at room temperature and for which $0.3 \leq (x + y)/z \leq 1.0$.

European Patent Office

# EUROPEAN SEARCH REPORT

Application Number

EP 89 10 9342

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| P,X | EP-A-0 315 954 (TORAY)<br>* Claims 1,2,6,7,18,19; page 3, lines 15-39,49-55; page 5, lines 9-17; page 5, example 1; page 6, example 2 *<br>--- | 1,2 | C 08 G 77/24<br>G 03 F 7/00 |
| A | EP-A-0 167 854 (NIPPON TELEGRAPH & TELEPHONE)<br>* Claims 1,9; page 9, lines 8-14 *<br>--- | 1 | |
| A | EP-A-0 255 303 (OKI ELECTRIC INDUSTRY)<br>* Claim 1 *<br>--- | 1 | |
| A | EP-A-0 163 538 (S.-I. FUKUYAMA)<br>* Claim 1; page 7, line 34; page 8, lines 3-14; page 9, lines 1-37 *<br>----- | 1 | |

TECHNICAL FIELDS SEARCHED (Int. Cl.4)

C 08 G
G 03 F

The present search report has been drawn up for all claims

| Place of search | Date of completion of the search | Examiner |
|---|---|---|
| THE HAGUE | 25-09-1989 | DEPIJPER R.D.C. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)